# EUROPEAN PATENT APPLICATION

(11) **EP 4 044 111 A1**
(43) Date of publication of application: **17.08.2022**
(21) Application number: 20875252.7
(22) Date of filing: 31.08.2020
(51) Int. Cl.: G06T 7/00, G06F 30/27, G06F 30/20, G06F 30/10

(54) **DESIGN ASSISTANCE DEVICE, DESIGN ASSISTANCE METHOD, AND DESIGN ASSISTANCE PROGRAM**

(30) Priority: 11.10.2019 JP 2019187627
(71) Applicant: Hitachi, Ltd., Tokyo 100-8280 (JP)
(72) Inventor: KATAYAMA, Erika, Tokyo 100-8280 (JP); KATAOKA, Ichiro, Tokyo 100-8280 (JP); ONODERA, Makoto, Tokyo 100-8280 (JP)
(74) Representative: MERH-IP Matias Erny Reichl Hoffmann Patentanwälte PartG mbB
(86) International application number: PCT/JP2020/032936
(87) International publication number: WO 2021/070514

(57) **Abstract**

A design assistance device 10 comprises: a determination rule definition unit 102 that defines a determination rule for determining whether a CAD model 103 violates a design guideline 101; a geometric shape recognition unit 105 that extracts, from the CAD model 103, a violation location violating the design guidelines 101, by using geometric shape recognition based on the determination rule defined by the determination rule definition unit 102; and a feature amount recognition unit 108 that identifies, from among violation locations, a violation location violating the design guidelines 101, by using feature amount recognition based on a prescribed feature amount of the violation location extracted by the geometric shape recognition unit 105.

## Description

### Technical Field

The present invention relates to a design support device, design support method, and design support program.

### Background Art

It has been known that a product or the like is designed on a computer using a CAD (Computer-Aided design) system.

In such CAD-based design, it is desirable to consider the guidelines for processing easiness in drilling and bending and assembling ease in welding and screwing. Furthermore, in CAD-based design, it is also desirable to consider the guidelines for inspection ease and accessibility to jigs which are important in maintenance of the product. Regarding these design guidelines, in some cases there are tens of thousands of rules for one product and usually checks are carried out by human work using a checklist or the like.

For example, let's assume that there is a design guideline that "the distance from a hole of stainless steel with a plate thickness of X mm to a bent portion should be Y mm or more". In this design guideline, quantitative rules that allow a check to be performed according to CAD shape are called "decision rules".

In order to perform automatic check on a CAD model (CAD design data) according to these decision rules, it is necessary to create a program that can be executed by combination of several functions and, if a threshold set for the decision rules is not satisfied, inform the designer that it is a non-conforming spot.

For example, Patent Literature 1 discloses a technique that "a feature value included in a 3D model is extracted and by applying a rule for the feature value, a decision is made as to whether it conforms to the rule or not". Patent Literature 2 discloses a technique that "a 3D positional relation between elements constituting a product is found and whether the positional relation is adequate or not according to a design rule".

### Citation List

### Patent Literature

PTL 1: Japanese Unexamined Patent Application Publication No. 2003-296383
PTL 2: Japanese Unexamined Patent Application Publication No. 2003-297870

### Summary of Invention

### Technical Problem

According to Patent Literature 1 and Patent Literature 2, when a decision rule for a check to be performed in advance is created, whether a CAD model satisfies the decision rule or not can be automatically checked.

Here, the result of automatic check may include noise. Here, noise means an over-detection result that is actually not a non-conforming spot but is recognized as a non-conforming spot in the check process. For example, in the case of the abovementioned design guideline that "the distance from a hole of stainless steel with a plate thickness of X mm to a bent portion should be Y mm or more", if a bent portion not on the same plane as the hole is detected, this is noise.

If the check result includes a lot of such noise, it takes time to scrutinize whether the check result indicates actual non-conforming spots or not. Therefore, in such an automatic check technique, how noise is reduced is important.

However, Patent Literature 1 and Patent Literature 2 disclose no concrete technique that reduces noise when a check result includes a lot of noise.

The present invention has been made in view of the above problem and one object of the present invention is to reduce noise that is recognized as a non-conforming spot in automatic check as to whether or not a CAD model satisfies a decision rule, though it is not a non-conforming spot against the decision rule, and detect a non-conforming spot with high accuracy.

### Solution to Problem

In order to solve the above problem, according to one aspect of the present invention, a design support device comprises: a decision rule definition section that defines a decision rule to decide whether a CAD model is against a guideline for design or not; a geometric shape recognition section that extracts a non-conforming spot against the guideline from the CAD model by geometric shape recognition according to the decision rule defined by the decision rule definition section; and a feature value recognition section that identifies a non-conforming spot against the guideline from among the non-conforming spots by feature value recognition according to a prescribed feature value of the non-conforming spot extracted by the geometric shape recognition section.

### Advantageous Effects of Invention

According to the present invention, in automatic check to decide whether or not a complicated CAD model satisfies a decision rule, noise that is recognized as a non-conforming spot though it is not a non-conforming spot against the decision rule is reduced, so that a non-conforming spot can be detected with high accuracy.

### Brief Description of Drawings

Fig. 1 is a block diagram that shows one example of the configuration of the design support device according to a first embodiment.
Fig. 2 is a flowchart that shows one example of overall processing in the design support device according to the first embodiment.
Fig. 3 is a diagram that shows one example of a computer in which the design support device according to the first embodiment is installed.
Fig. 4 is a view that shows one example of the CAD model as the object to be checked (check object) in the first embodiment.
Fig. 5 is a view that shows a CAD model representing an ordinary bolt shape.
Fig. 6A is a flowchart that shows one example of processing by the geometric shape recognition section in the first embodiment.
Fig. 6B is a view that gives a supplementary explanation of processing by the geometric shape recognition section in the first embodiment.
Fig. 7 is a view that shows one example of non-conformity result output by the geometric shape recognition section in the first embodiment.
Fig. 8 is an example of image feature values in the case that one non-conformity result output by the geometric shape recognition section in the first embodiment is converted into image data in a plurality of directions.
Fig. 9 is a view that shows one example of non-conformity result output by the feature value recognition section referring to the image feature DB in the first embodiment.
Fig. 10 is a view that shows an example of the CAD model in a second embodiment.
Fig. 11 is a flowchart that shows one example of processing by the geometric shape recognition section in the second embodiment.
Fig. 12 is a view that shows an example of non-conformity result output by the geometric shape recognition section in the second embodiment.
Fig. 13 is a view that shows one example of non-conformity result output by the feature value recognition section in the second embodiment.

### Description of Embodiments

Hereinafter, embodiments of the present invention will be described referring to drawings. In the description below, the same or similar elements are designated by the same reference signs and their repeated description is omitted. For the embodiment described later, only the differences from the already described embodiment will be explained and repeated description is omitted.

The following explanations of the embodiments and the configurations and processing shown in the figures are general information required to understand and embody the present invention and are not intended to limit the embodiments according to the present invention. In addition, various embodiments and variations may be, in part or in whole, combined in a mutually compatible range without departing from the gist of the present invention.

### First Embodiment

### <Basic configuration of the design support device 10 according to the first embodiment>

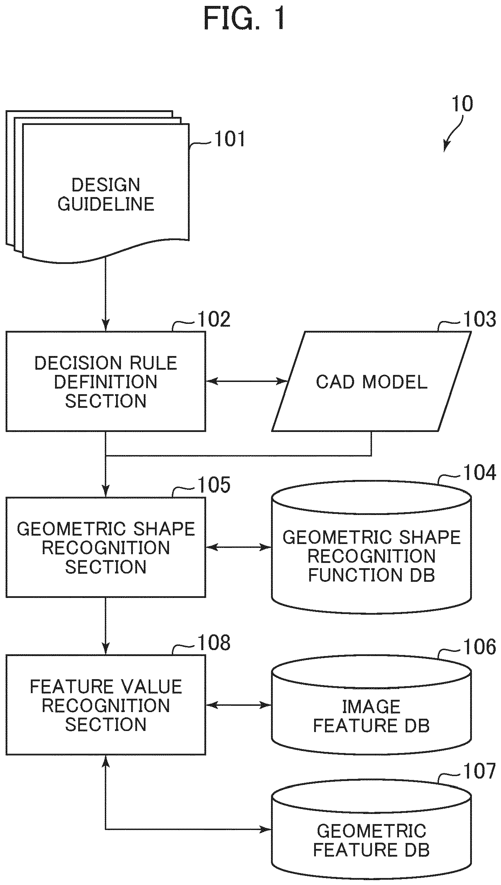

Fig. 1 is a block diagram that shows one example of the configuration of the design support device 10 according to the first embodiment. As shown in Fig. 1, the design support device 10 includes a design guideline 101, a decision rule definition section 102, a CAD (Computer Aided Design) model 103, a geometric shape recognition function DB (Data Base) 104, a geometric shape recognition section 105, an image feature DB 106, a geometric feature DB 107, and a feature value recognition section 108.

The design guideline 101 is a knowledge database that collects the rules to be considered in designing. The design guideline 101 includes the specifications of manufacturing equipment and tools, criteria of stable machining, and design rules typified by standards such as JIS. For example, the design guideline includes position rules for end portions, bends and holes and accessibility to manufacturing tools.

The decision rule definition section 102 defines the format to perform verification on a CAD model, for example, a decision rule expressed by a mathematical formula, according to a design rule included in the design guideline 101.

The CAD model 103 includes the CAD model as a check object.

The geometric shape recognition function DB 104 stores a plurality of procedure functions to recognize a geometric shape included in the CAD model as the check object (hereinafter called common functions). A common function is a function that is made a basic element so that it can be individually called from a CAD program which runs on a computer. A concrete example of a common function will be explained later.

The geometric shape recognition section 105 creates a rule of checks that can be performed on the CAD program, by combining the decision rule defined by the decision rule definition section 102 and a common function extracted from the geometric shape recognition function DB 104, and performs a check of the CAD model 103 as the check object according to that rule.

Here, the result of the check performed in the geometric shape recognition section 105 usually includes both a non-conforming spot against the rule and an over-detected spot which is a noise, that is not a nonconforming spot but is detected as a non-conforming spot.

For this reason, the feature value recognition section 108 decides whether the rule is satisfied or not, using the feature value of the CAD model 103 as the check object. For example, the feature value recognition section 108 refers to the image feature DB 106 and decides whether the rule is satisfied or not, according to the image-like feature value extracted from the CAD model 103 as the check object (hereinafter called the image feature value).

Further, the feature value recognition section 108 refers to the geometric feature DB 107, and decides whether the rule is satisfied or not, according to a geometric-like feature value (hereinafter called the geometric feature value) extracted from the CAD model 103 as the check object.

The feature value recognition section 108 decides whether the rule is satisfied or not, according to either the image feature value or the geometric feature value, or both. The feature value here is not limited to an image feature value and geometric feature value, but any feature value that features the CAD model 103 may be used.

The feature value recognition section 108 checks the three-dimensional direction, position, etc. of a curved surface that is usually difficult to identify only by the geometric shape recognition section 105, paying attention to the feature value of the CAD model 103 as the check object, so that only a non-conforming spot can be identified quickly and accurately.

### <Overall processing in the design support device 10 according to the first embodiment>

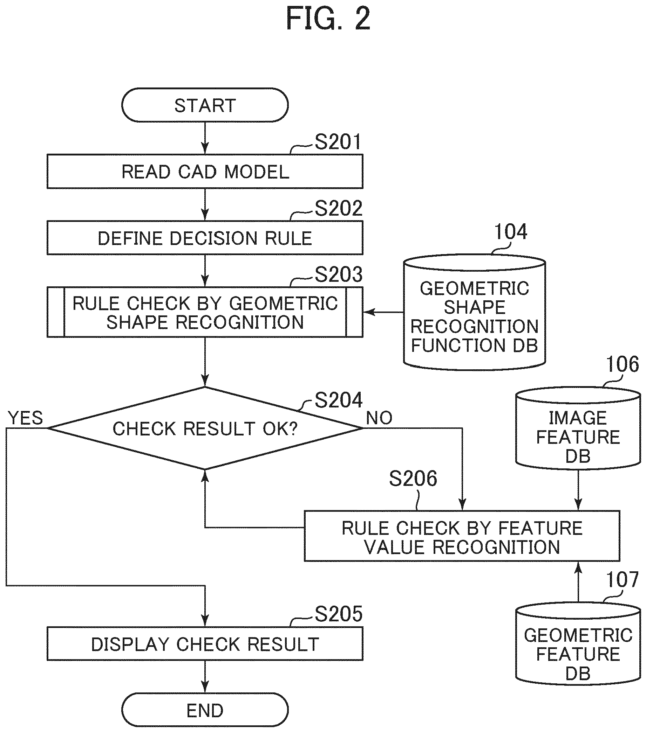

Fig. 2 is a flowchart that shows one example of overall processing in the design support device 10 according to the first embodiment. The design support device 10 starts overall processing according to an instruction from the user.

First, at Step S201, the decision rule definition section 102 reads the design guideline 101 and the CAD model 103 as the check object. Next, at Step S202, the decision rule definition section 102 defines the decision rule to be used for check, according to the design guideline 101 read at Step S201. Next, at Step S203, the geometric shape recognition section 105 compares a threshold with the rule created by combination of the decision rule defined by the decision rule definition section 102 and a common function stored in the geometric shape recognition function DB 104, to perform rule check based on geometric shape recognition.

Concrete examples of common functions are explained below. Common functions include: common functions that provide the geometric feature search function to search a hole or end portion; common functions that provide the shape feature value calculating function to measure the distance between surfaces or the like; common functions that provide the shape creating function to create a surface, point or the like; and common functions that provide the numerical value calculating function to perform four arithmetic operations and calculate maximum and minimum values, though not limited thereto.

Next, at Step S204, the design support device 10 evaluates whether the result of rule check at Step S203 or Step S206, which will be described later, is over-detection or not. For the evaluation of the result of rule check at Step S204, the amount of noise is judged, for example, using the precision and recall method. At Step S204, if it is decided by rule check based on geometric shape recognition that the amount of noise is small and over-detection has not been made (Yes at Step S204), the design support device 10 highlights the non-conforming spot on a display 31 which will be described later, as shown by Step S205 to inform the operator of it.

Next, at Step S204, if it is decided by rule check based on geometric shape recognition that there is a lot of noise and over-detection has been made (No at Step S204), the feature value recognition section 108 performs rule check based on feature value recognition shown at Step S206. By rule check based on feature value recognition, noise is reduced from the check result and only the non-conforming spots that should be checked are extracted. Feature value recognition at Step S206 can be performed by either the method by reference to the image feature DB 106 or the method by reference to the geometric feature DB 107, or combination of these methods, as mentioned above, though the method is not limited thereto. After Step S206 is ended, the design support device 10 moves the processing sequence to Step S204.

The processing sequence returns from Step S206 to Step S204 and if the check result is again NG (No at Step S204) and the processing sequence is moved to Step S206, at Step S206 rule check is performed according to a feature value different from the feature value used at the previous time of Step S206. Since rule check is thus performed according to a plurality of different feature values, noise reduction can be achieved using any of these feature values.

### <Computer in which the design support device 10 is installed>

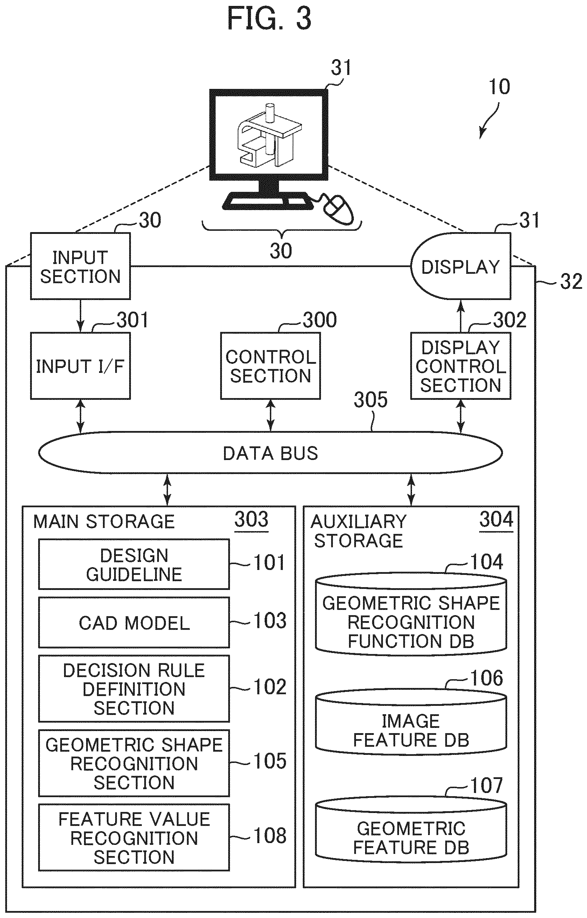

Fig. 3 is a diagram which shows one example of a computer in which the design support device 10 according to the first embodiment is installed. As shown in Fig. 3, the design support device 10 includes a processing section 32 as a computer with an input section 30 and a display 31.

The input section 30 and display 31 provide an operation environment by GUI (graphic user interface) to the user.

In the processing section 32, a control section 300, an input interface 301 to receive the design guideline 101 entered from the input section 30 and the CAD model 103 (hereinafter, input I/F), a display control section 302 to control the display 31, a main storage 303, and an auxiliary storage 304 are connected with each other via a data bus 305.

The main storage 303 stores the design guideline 101 and CAD model 103 and also stores the program that enables the computer to function as the decision rule definition section 102, geometric shape recognition section 105, and feature value recognition section 108. The auxiliary storage 304 stores various data in the geometric shape recognition function DB 104, image feature DB 106, and geometric feature DB 107, and the program that enables these databases to function.

In the computer that realizes the design support device 10, the program to realize the design support device 10 is read from the auxiliary storage 304 and executed by cooperation of the control section 300 and main storage 303 so that the design support device 10 is realized. Alternatively, the program to realize the design support device 10 may be read from a portable recording medium by a reading device or acquired from an external computer by communication via a network interface (not shown).

The computer hardware of the processing section 32 may be, in part or in whole, replaced by a DSP (Digital Signal Processor), FPGA (Field-Programmable Gate Array), or GPU (Graphics Processing Unit). In addition, the computer hardware of the processing section 32 may be, in part or in whole, concentrated on a server on the network or distributed so that a plurality of users can work together via the network.

### (CAD model 103 as the check object in the first embodiment)

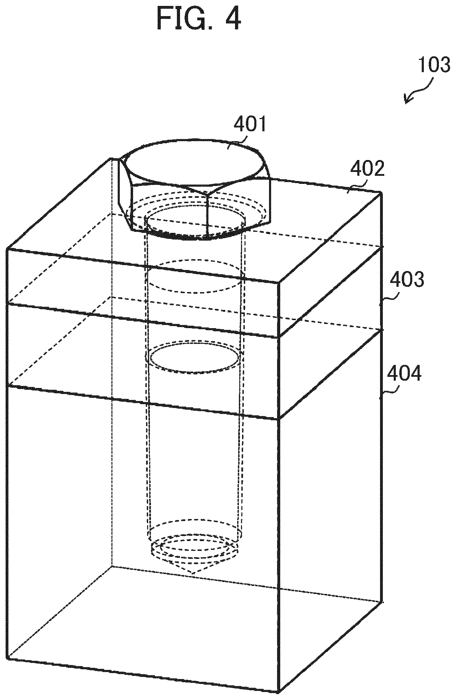

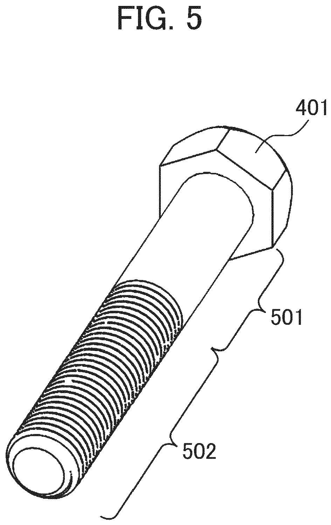

Fig. 4 is a view that shows one example of the CAD model 103 as the check object in the first embodiment. Fig. 5 is a view that shows a CAD model representing an ordinary bolt shape. In the first embodiment, as shown in Fig. 4, the object to be checked is the CAD model 103 in which a bolt 401 is connected with three components and an example of automatic check is given in which a decision is made as to whether or not the bolt holes of the components to be connected are adequate in size.

In the CAD model 103 shown in Fig. 4, a first component to be penetrated 402, a second component to be penetrated 403 and a fastening component 404 are modeled as the components to be penetrated by the bolt 401. Usually the bolt 401 has a penetrating portion 501 and a screw portion 502 to connect the penetrating portion and another component, as shown in Fig. 5. For example, in the design rule for the CAD model 103 shown in Fig. 4, a decision is made as to whether or not the hole diameter of the fastening component 404 to be connected with the screw portion 502 of the bolt 401 is adequate.

### <Processing by the geometric shape recognition section 105 in the first embodiment>

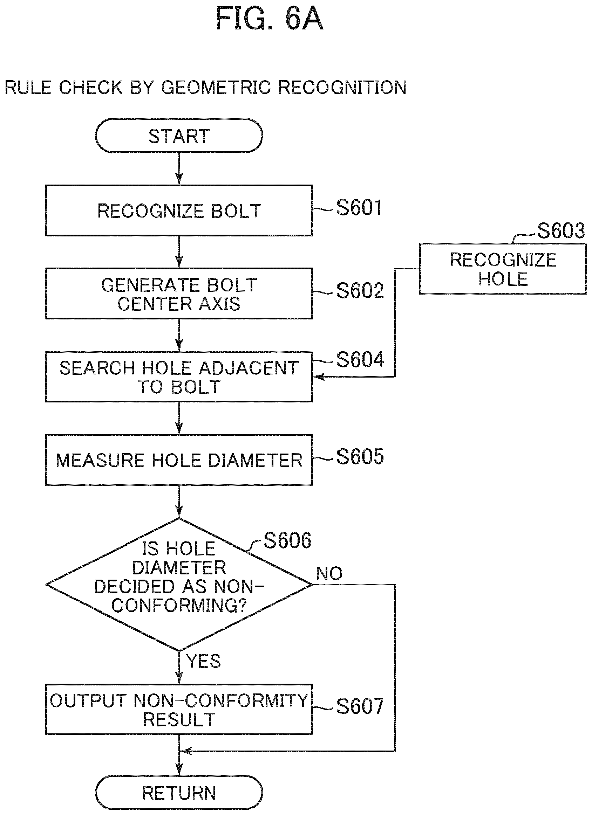

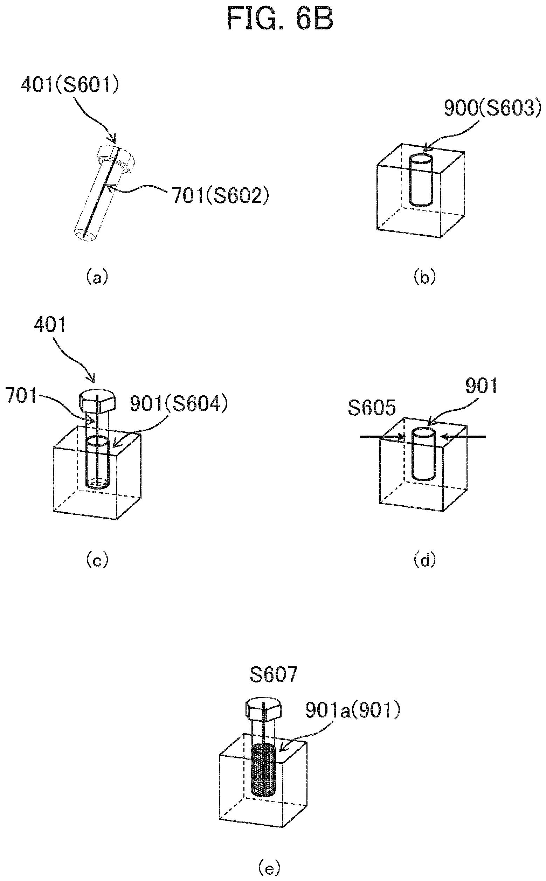

Next, details of processing at Step S203 shown in Fig. 2 according to the first embodiment will be explained referring to Fig. 6A and Fig. 6B. Fig. 6A is a flowchart that shows an example of processing by the geometric shape recognition section 105 in the first embodiment. Fig. 6B is a view that gives a supplementary explanation of processing by the geometric shape recognition section 105 in the first embodiment. The processing at Steps S601 to S607 in Fig. 6A is realized by executing the common functions previously stored in the geometric shape recognition function DB 104.

First, at Step S601, the geometric shape recognition section 105 recognizes the bolt 401 included in the CAD model 103 as the check object (see Fig. 6B (a)). As the recognition method, a method that recognizes the bolt according to attributes, a method that recognizes the bolt by searching similar shapes according to the degree of bolt shape similarity and the like are available, though the method is not limited thereto.

Next, at Step S602, the geometric shape recognition section 105 generates the central axis 701 of the recognized bolt 401 (see Fig. 6B (a)). At Step S603, the geometric shape recognition section 105 recognizes the hole 900 included in the CAD model 103 as the check object (see Fig. 6B (b)).

At Step S604, the geometric shape recognition section 105 searches and obtains a hole 901 existing adjacent to the central axis 701 of the bolt 401 generated at Step S602 (see Fig. 6B (d)). Then, at Step S605, the geometric shape recognition section 105 measures the diameter of the hole 901 existing adjacent to the bolt 401, which has been obtained by search at Step S604 (see Fig. 6B (d)).

Next, at Step S606, the geometric shape recognition section 105 decides whether the hole diameter measured at Step S605 is non-conforming against a threshold or not. If the hole diameter measured at Step S605 is non-conforming against the threshold (Yes at Step S606), the geometric shape recognition section 105 identifies the hole 901 whose diameter is non-conforming against the threshold, as a non-conforming part 901a and outputs a non-conformity result (Step S607, see Fig. 6B (e)). After Step S607 is ended, the geometric shape recognition section 105 moves the processing sequence to Step S204 in Fig. 2.

On the other hand, if the hole diameter measured at Step S605 is not non-conforming against the threshold (No at Step S606), the geometric shape recognition section 105 approves (OKs) the check result of the hole 901 and ends the processing sequence in Fig. 6A and moves the processing sequence to Step S204 in Fig. 2.

### <Example of non-conformity result by geometric shape recognition in the first embodiment>

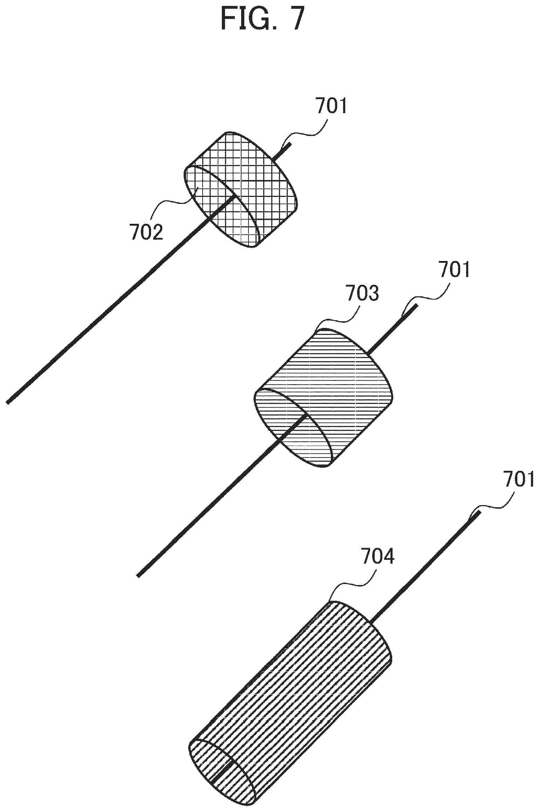

Fig. 7 is a view that shows one example of non-conformity result output by the geometric shape recognition section 105 in the first embodiment. Fig. 7 shows a case that three non-conforming spots are extracted as a non-conformity result decided by geometric shape recognition in the first embodiment. Specifically, Fig. 7 shows a case that the hole of the first component to be penetrated is expressed by a cylindrical surface 702, the hole of the second component to be penetrated is expressed by a cylindrical surface 703, the hole of the fastening component 404 is expressed by a cylindrical surface 704, and a non-conformity result is output, including their positional relation with the central axis 701 of the bolt.

When the three non-conforming spots are extracted as shown in Fig. 7, in order to determine the hole diameter of the bolt fastening component 404, the hole adjacent to the end of the central axis 701 of the bolt, among the three holes, must be evaluated. However, usually it is difficult to identify the hole of the fastening component 404 from the three results output as non-conformity only by geometric shape recognition even if details of the positional relation of the cylindrical surfaces 702, 703, and 704 with the bolt central axis 701 are given.

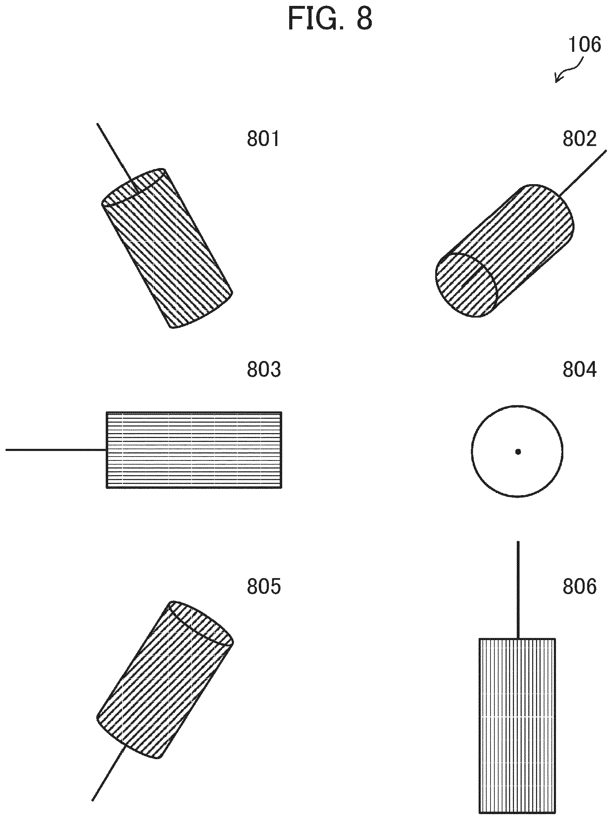

Therefore, reference is made to the image feature DB 106 that stores image feature value data on the bolt central axis 701 and the hole and position of the bolt fastening component 404 and whether there is non-conformity or not, and the hole of the fastening component 404 and whether there is non-conformity or not are identified. In this embodiment, since the object is a 3D CAD, it is desirable to use image data as projections in not only one direction but also a plurality of directions for one non-conformity result as shown in Fig. 8. Fig. 8 is an example of image feature values in the case that one non-conformity result output by the geometric shape recognition section 105 in the first embodiment is converted into image data in a plurality of directions. Fig. 8 shows image data 801 to 806 as an example of image data as projections in a plurality of directions for the same non-conformity result. When one non-conformity result has image feature values for image data in a plurality of directions, the accuracy in narrowing down a non-conforming spot according to the image feature values can be improved in 3D CAD.

In addition, reference is made to a lot of image data on the bolt central axis 701 and the cylindrical surface 704 representing the hole of the fastening component 404, which is stored in the image feature DB 106, for example, as teacher data in machine learning, and based on the result of the machine learning, among the data on the three non-conforming spots shown in Fig. 7, the non-conforming spot is narrowed down to the bolt central axis 701 and the cylindrical surface 704 representing the hole of the fastening component 404 from the positional relation between the bolt central axis 701 and the cylindrical surface. The use of machine learning can improve the accuracy in narrowing down a non-conforming spot according to image feature values. Alternatively, instead of machine learning, non-conforming spot data may be narrowed down according to the image data itself stored in the image feature DB 106.

Here, as a method of identifying a non-conforming spot according to image feature values, for example, machine learning is available and machine learning includes genetic algorithm, binary tree search, and convolutional neutral network, though it is not limited thereto in this embodiment. For example, machine learning based on at least one of the following techniques may be adopted: deep neutral network, decision tree learning, association rule learning, inductive logic programming, support vector machine, clustering, Bayesian network, enforced learning, expression learning, principal component analysis, extreme learning machine and other learning techniques.

### <Effects of the first embodiment>

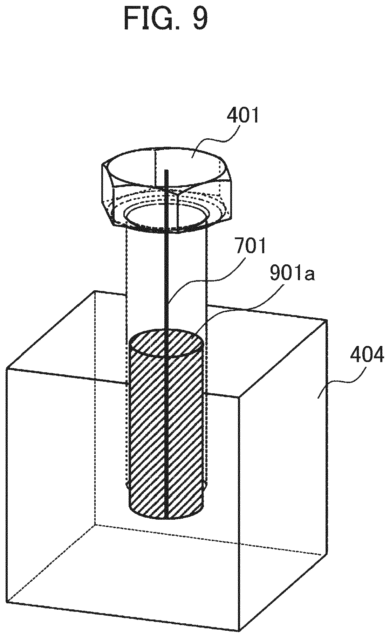

According to this embodiment, as Fig. 9 shows an example of the non-conformity result output by the feature value recognition section 108 referring to the image feature DB 106 in the first embodiment, regarding the bolt 40, the diameter of the hole of the fastening component 404 is evaluated so that only the non-conforming spot 901a can be extracted by the feature value recognition section 108. Therefore, noise is reduced and non-conformity recognition accuracy is improved.

In conventional automatic check based on shape recognition and geometric operation, it is difficult to narrow down a non-conforming spot and over-detection is likely to occur, but in this embodiment objects of check for non-conformity are first narrowed down by geometric shape recognition and in the case of over-detection, non-conforming spots are further narrowed down according to feature values, so over-detection can be reduced.

### Second Embodiment

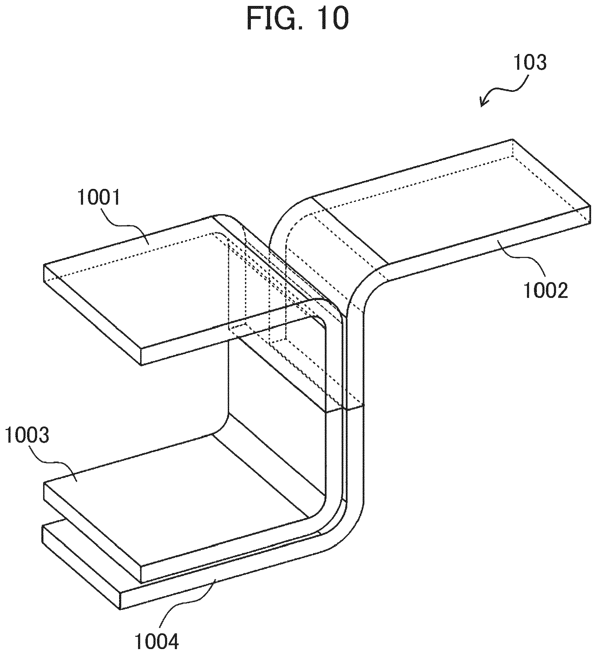

In the second embodiment, a method of identifying a non-conforming spot that uses the geometric feature DB 107 in the configuration of Fig. 1 will be explained using the CAD model 103 shown in Fig. 10. Fig. 10 is a view that shows an example of the CAD model 103 in the second embodiment.

The CAD model 103 shown in Fig. 10 includes four bent parts 1001, 1002, 1003, and 1004. In the second embodiment, a decision is made as to whether or not the distance between parts among these four bent parts 1001 to 1004 satisfies a rule.

Here, regarding the four bent parts 1001 to 1004 that each have a bent portion, in the case of parts that have the same bending direction like the bent part 1003 and bent part 1004, if the distance between the parts is smaller than a threshold, interference might occur during assembling and thus it is detected as non-conforming. On the other hand, in the case of the bent part 1001 and bent part 1002 that are different in bending direction, even if the distance between the parts is smaller than a threshold, interference is less likely to occur since they are bent in different directions. Therefore, it need not be identified as a non-conforming spot.

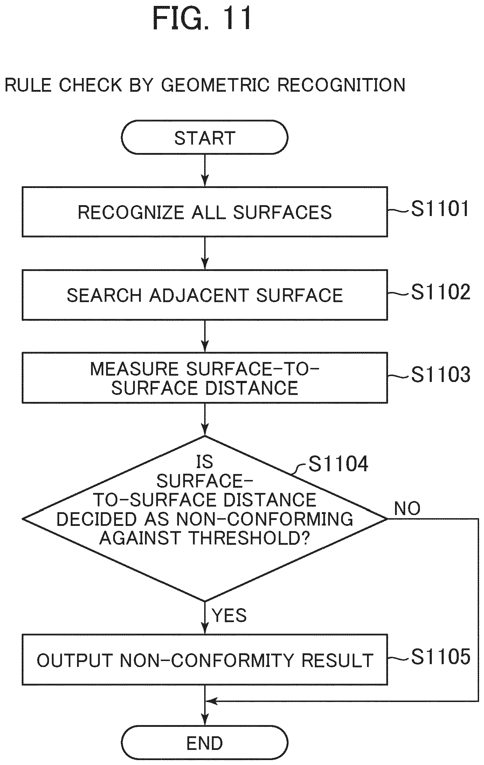

In the conventional method of identifying a non-conforming spot using only the geometric shape recognition section 105, it takes a huge amount of computing time to calculate the bending directions of all the bent parts included in the CAD model 103. Therefore, in the second embodiment, the geometric shape recognition section 105 first identifies a spot where the distance between the plates of bent parts (between surfaces) is smaller than a threshold, according to the processing flow of the geometric shape recognition section 105 as shown in Fig. 11 so that the computing time is shortened.

### <Processing by the geometric shape recognition section 105 in the second embodiment>

The processing at Step S203 shown in Fig. 2 will be explained in detail referring to Fig. 11. Fig. 11 is a flowchart that shows one example of processing by the geometric shape recognition section 105 in the second embodiment. The processing at Steps S1101 to S1105 in Fig. 11 is performed by executing the common functions previously stored in the geometric shape recognition DB 104.

First, at Step S1101, the geometric shape recognition section 105 recognizes all the surfaces in the read CAD model 103 (hereinafter called surfaces).

Next, at Step S1102, the geometric shape recognition section 105 searches a surface adjacent to a surface as a reference. Next, at Step S1103, the geometric shape recognition section 105 measures the surface-to-surface distance between the reference surface and the adjacent surface.

Next, at Step S1104, the geometric shape recognition section 105 decides whether or not the surface-to-surface distance measured at Step S1104 is smaller than the threshold (non-conforming). If the surface-to-surface distance measured at Step S1103 is non-conforming against the threshold (Yes at Step S1104), the geometric shape recognition section 105 identifies the surface whose surface-to-surface distance is non-conforming against the threshold, as a non-conforming spot, and outputs a non-conformity result (Step S1105). After Step S1105 is ended, the geometric shape recognition section 105 moves the processing sequence to Step S204 in Fig. 2.

On the other hand, if the surface-to-surface distance measured at Step S1103 is not non-conforming against the threshold (No at Step S1104), the geometric shape recognition section 105 approves (OKs) the result of check of the surface-to-surface distance, ends the processing sequence in Fig. 11 and moves the processing sequence to Step S204 in Fig. 2.

### <Example of non-conformity result by geometric shape recognition in the second embodiment>

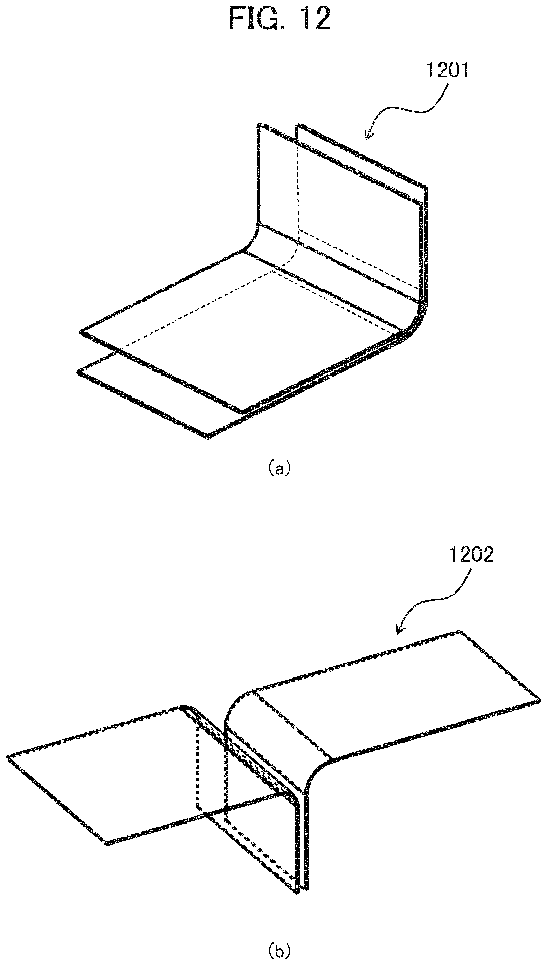

Fig. 12 is a view that shows one example of non-conformity result output by the geometric shape recognition section in the second embodiment. Fig. 12 shows a case that two non-conforming spots are extracted as the non-conformity result decided by geometric shape recognition in the second embodiment. Specifically, Fig. 12 shows a case that two sets of opposing surfaces are extracted. In Fig. 12, regarding the sets of opposing surfaces, the first one is a group of surfaces 1201 that are the same in bending direction as shown in Fig. 12 (a). The second one is a group of surfaces 1202 that are opposite in bending direction as shown in Fig. 12 (b). Fig. 12 indicates that the geometric shape recognition section 105 narrows down the object to two sets of opposing surfaces among many surfaces of the 3D CAD model 103 shown in Fig. 10.

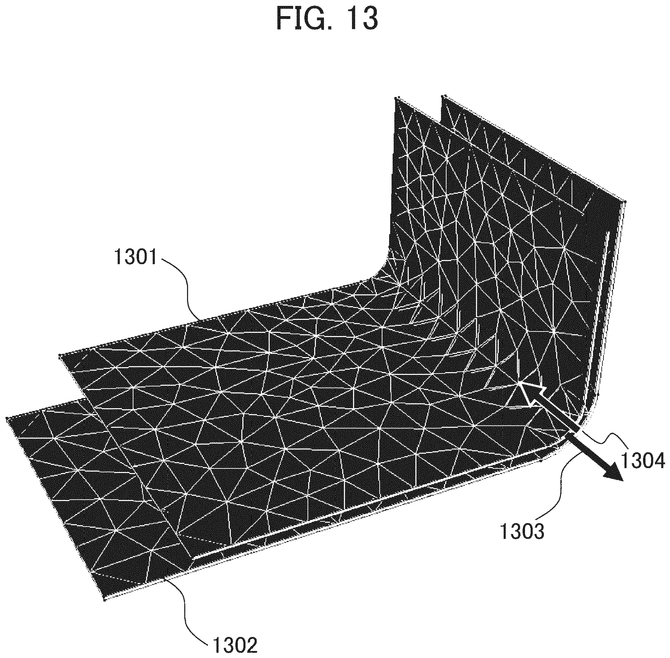

However, the surface group 1201 shown in Fig. 12 (a) is a spot which should be identified as a non-conforming spot but the surface group 1202 shown in Fig. 12 (b) is over-detection, namely noise. Therefore, the bending directions in the surface group 1201 and the surface group 1202 are identified according to the geometric feature DB 107. Specifically, the surface groups are converted into STL (Stereolithography) data as shown in Fig. 13. Fig. 13 is a view that shows one example of non-conformity result output by the feature value recognition section in the second embodiment. Fig. 13 shows STL data obtained by conversion of the surface group 1201 and the other surface groups are also converted in the same way. Data obtained by conversion of surface groups is not limited to STL data but any data format that enables recognition of geometric feature values may be adopted.

For example, as shown in Fig. 13, regarding the conversion result 1301 and conversion result 1302 that are obtained by converting the two surfaces of the surface group 1201 into STL data, the normal direction of each surface is calculated. By calculating the inner product of the normal vector 1303 of the conversion result 1301 and the normal vector 1303 of the opposite conversion result 1302, whether the bending directions of the two surfaces of the surface group 1201 are the same or opposite can be recognized. Fig. 13 shows the result of extraction as a non-conforming spot by the feature value recognition section 108.

The geometric shapes that the geometric shape recognition section 105 recognizes are line-to-point distance, arc center, hole diameter and so on in addition to the abovementioned surface-to-surface distance. Furthermore, the geometric feature value is not limited to a normal vector, but instead it may be another kind of geometric feature value such as curvature.

### <Effects of the second embodiment>

According to this embodiment, as shown in Fig. 13, noise is reduced and the non-conformity recognition accuracy is improved by combining feature value recognition, unlike the conventional method in which only the geometric shape recognition section 105 is used and two spots, which are the surface group 1201, an actual non-conforming spot, and the surface group 1202, not an actual non-conforming spot, are extracted, and noise is included.

For a small-scale CAD model with thousands of surfaces in which the number of components is small, there is no problem with rule check by the conventional method that only uses the geometric shape recognition section 105 or the feature value recognition section 108. However, for a CAD model with hundreds of thousands to tens of millions of surfaces in which the number of components is large, multiple-stage check as in the present invention is effective to shorten the computing time and recognize non-conformity with high accuracy.

The present invention is not limited to the above embodiments but includes many variations. For example, the above embodiments have been described in detail for easy understanding of the present invention; however the present invention is not limited to a structure which includes all the elements described above. Unless inconsistent, an element of an embodiment may be replaced by an element of another embodiment or an element of an embodiment may be added to another embodiment. Also, for some elements of each embodiment, addition, deletion, replacement, integration or distribution of elements can be made. The constituent elements and processes indicated in the embodiments can be distributed or integrated according to processing efficiency or implementation efficiency as appropriate.

### List of Reference Signs

10...design support device,
101...design guideline,
102...decision rule definition section,
103...CAD model,
104...geometric shape recognition function DB,
105...geometric shape recognition section,
106...image feature DB,
107...geometric feature DB,
108...feature value recognition section

## Claims

1. A design support device comprising:
a decision rule definition section that defines a decision rule to decide whether a CAD model is against a guideline for design or not;
a geometric shape recognition section that extracts a non-conforming spot against the guideline from the CAD model by geometric shape recognition according to the decision rule defined by the decision rule definition section; and
a feature value recognition section that identifies a non-conforming spot against the guideline from among the non-conforming spots by feature value recognition according to a prescribed feature value of the non-conforming spot extracted by the geometric shape recognition section.

2. The design support device according to Claim 1, wherein if the non-conforming spots extracted by the geometric shape recognition section are over-detected, a non-conforming spot against the guideline is identified from among the non-conforming spots by the feature value recognition.

3. The design support device according to Claim 2, wherein even if non-conforming spots against the guideline are identified by the feature value recognition according to a first feature value as the prescribed feature value but the non-conforming spots are still over-detected, a non-conforming spot against the guideline is identified according to a second feature value different from the first feature value, by the feature value recognition.

4. The design support device according to Claim 1, wherein
the prescribed feature value is an image feature value of the non-conforming spot, and
the feature value recognition section refers to an image feature database storing an image feature value of a part against the decision rule and identifies a non-conforming spot against the guideline according to the image feature value.

5. The design support device according to Claim 4, wherein the image feature database stores, as an image feature value of the part against the decision rule, an image feature value of each of a plurality of images of the one part that are taken at different view angles.

6. The design support device according to Claim 4, wherein the feature value recognition section refers to the image feature database as a database storing teacher data for machine learning and identifies a non-conforming spot against the guideline according to a result of the machine learning.

7. The design support device according to Claim 1, wherein
the prescribed feature value is a geometric feature value of the non-conforming spot, and
the feature value recognition section identifies a non-conforming spot against the guideline according to the geometric feature value.

8. The design support device according to Claim 7, wherein the feature value recognition section converts a non-conforming spot extracted by the geometric shape recognition section, into prescribed data from which a geometric feature value can be recognized, and identifies a non-conforming spot against the guideline according to the geometric feature value on the prescribed data.

9. The design support device according to Claim 8, wherein
the prescribed data is STL (Stereolithography) data, and
the feature value recognition section identifies a non-conforming spot against the guideline according to the geometric feature value on the STL data.

10. A design support method that is performed by a design support device, wherein the design support device includes the steps of:
defining a decision rule to decide whether a CAD model is against a guideline for design or not;
extracting a non-conforming spot against the guideline from the CAD model by geometric shape recognition according to the defined decision rule; and
identifying a non-conforming spot against the guideline from among the non-conforming spots by feature value recognition according to a prescribed feature value of the extracted non-conforming spot.

11. A design support program that enables a computer to function as the design support device according to any one of Claims 1 to 9.
